# EUROPÄISCHE PATENTSCHRIFT

(11) **EP 1 707 037 B1**
(45) Veröffentlichungstag und Bekanntmachung des Hinweises auf die Patenterteilung: **06.01.2010**
(21) Anmeldenummer: 05700011.9
(22) Anmeldetag: 21.01.2005
(51) Int. Cl.: H05K 3/24, H05K 1/16

(54) **VERFAHREN ZUM HERSTELLEN EINES LEITERPLATTENELEMENTS SOWIE LEITERPLATTENELEMENT**
METHOD FOR THE PRODUCTION OF A CIRCUIT BOARD ELEMENT AND CIRCUIT BOARD ELEMENT
PROCEDE DE FABRICATION D'UN ELEMENT DE CARTE DE CIRCUITS IMPRIMES ET ELEMENT DE CARTE DE CIRCUITS IMPRIMES

(30) Priorität: 23.01.2004 AT 852004
(43) Veröffentlichungstag der Anmeldung: 04.10.2006
(73) Patentinhaber: AT & S AUSTRIA TECHNOLOGIE & SYSTEMTECHNIK Aktiengesellschaft, A-8700 Leoben-Hinterberg (AT)
(72) Erfinder: BAUER, Wolfgang, A-8055 Graz (AT); STAHR, Johannes, A-8600 Bruck an der Mur (AT)
(74) Vertreter: Sonn & Partner Patentanwälte
(86) Internationale Anmeldenummer: PCT/AT2005/000010
(87) Internationale Veröffentlichungsnummer: WO 2005/072035

(56) Entgegenhaltungen:
- EP-A- 1 102 523
- EP-A- 1 327 995
- US-A- 4 870 746
- US-A1- 2003 132 025
- US-A1- 2003 150 101
- US-A1- 2003 157 264
- US-A1- 2004 239 474

## Beschreibung

Die Erfindung betrifft ein Verfahren zum Herstellen eines Leiterplattenelements sowie weiters ein Leiterplattenelement, wiebeispielsweise aus EP 1 102 523 A und US 2003/0132025 A bekannt. Hierbei wird auf einer strukturierten, aufgerauten Leiterlage eine Lötstoppmaske angebracht, die mit Öffnungen versehen wird, durch die hindurch Metallbeschichtungen, insbesondere auch mit Gold, vorgesehen werden.

Unter "Leiterplattenelement" ist hier eine einseitige oder doppelseitige Leiterplatte ebenso wie eine Multilayer-Leiterplatte zu verstehen, wobei primär wesentlich ist, dass ein Substrat, üblicherweise aus einer Epoxid-Harzschicht, mit zumindest einer darauf aufgebrachten metallischen, elektrisch leitenden Lage, in der Regel aus Kupfer, vorliegt. Die metallische Lage wird hier als "Leiterlage" bezeichnet. Diese Leiterlage kann eine Außenlage oder aber - im Fall eines Multilayers - eine Innenlage sein.

Es ist bereits vorgeschlagen worden, lokal an Stellen, wo elektrische Bauelemente anzubringen sind, eine Edelmetallschicht, insbesondere aus Silber, auf der Kupfer-Leiterlage anzubringen. Dies geschieht vor allem dort, wo in einem Druckverfahren PTF-Bauelemente (PTF-Polymer Thick Film - Polymerer Dickfilm) aufgebracht werden, wobei es sich hierbei insbesondere um PTF-Widerstände handelt. Die Edelmetallschicht zwischen dem Kupfer der Leiterlage und der PTF-Paste der Bauelemente verbessert die Stabilität der Schaltung, die sonst beispielsweise unter Feuchteeinfluss beeinträchtigt wird; die Edelmetallschicht bildet insofern eine "Sperrschicht", als sie bei Feuchteeinfluss eine Korrosion von Kupfer, etwa beim Aushärten der PTF-Paste, vermeiden hilft. Andererseits verbessert sie den elektrischen Kontakt zwischen dem Kupfer der Leiterlage und der PTF-Paste.

Von Nachteil ist bei diesem Vorschlag jedoch, dass die Edelmetallschicht nur an örtlich sehr begrenzten Stellen aufgebracht werden darf, nämlich genau dort, wo das Bedrucken mit der PTF-Paste erfolgen soll; würde man nämlich die Edelmetallschicht vollflächig auf der Kupfer-Leiterlage aufbringen, so würde die Haftung vom darüber anzubringenden Schichten stark beeinträchtigt werden. Beispielsweise wäre im Fall einer Verpressung zum Multilayer die notwendige interlaminare Haftung zu einer darüber angebrachten Leiterplatten-Struktur nicht mehr gegeben, und es käme beim Bestücken eines solchen Leiterplattenelements zu einer Delamination und damit zu einem Totalausfall des Leiterplattenelements. Sofern die Leiterlage eine Außenlage ist, d.h. eine Epoxidharz/Leiterlagen-Struktur nicht mehr aufgebracht wird, ist es üblicherweise für das Bestücken mit Bauelementen notwendig, auf der Außenlage eine Lötstoppmaske herzustellen, und im Fall einer Edelmetallschicht würde auch eine derartige Lötstoppmaske nur schlecht haften. Aus diesen Gründen wird wie erwähnt das Edelmetall nur örtlich stark begrenzt aufgebracht, und die übrige Kupfer-Leiterlagenoberfläche wird bei der weiteren Bearbeitung des Leiterplattenelements mit einer gesonderten Haftvermittlerschicht bedeckt, um so entweder das Anbringen einer Lötstoppmaske oder aber das Verpressen zum Multilayer zu begünstigen.

Für die bloß partielle Anbringung des Edelmetalls in örtlich begrenzten Bereichen der Leiterlage sind jedoch eigene Prozessschritte erforderlich, nämlich die Anbringung einer Maskierungsschicht und das Entfernen der Maskierungsschicht; nichtsdestoweniger kommt es im Bereich der Edelmetalloberfläche immer wieder zum Abheben von darauf befindlichen Materialien und somit zu Ausfällen.

Es ist nun Aufgabe der Erfindung, ein Verfahren zum Herstellen eines Leiterplattenelements bzw. ein Leiterplattenelement wie eingangs angeführt anzugeben, wobei im Zuge der Herstellung der Aufwand und die Kosten für die Prozessschritte der Maskierung und der Demaskierung erübrigt werden können, so dass eine wesentlich vereinfachte Herstellung erzielt wird, und wobei nichtsdestoweniger eine ausgezeichnete Haftung der einzelnen Schichten aneinander ermöglicht wird, und dies ohne dass eine eigene (zusätzliche) Haftvermittlerschicht auf der Leiterlage notwendig ist.

Zur Lösung dieser Aufgabe sieht die Erfindung ein Verfahren bzw. ein Leiterplattenelement wie in den unabhängigen Ansprüchen angegeben vor.

Vorteilhafte Ausführungsformen und Weiterbildungen sind in den abhängigen Ansprüchen angegeben.

Bei der erfindungsgemäßen Technik bildet die Edelmetallschicht selbst eine Haftvermittlerschicht, auf der das Material von durch Aufdrucken erzeugten Bauelementen, insbesondere PTF-Widerständen, aber auch Lötmaterial oder Adhäsivmaterial im Falle einer Klebebefestigung von vorgefertigten Bauelementen, und auch von nachfolgenden Schichten, wie etwa einer weiteren Leiterplattenstruktur oder aber einer Lötstopmaske, gut haftet. Diese gute Haftung wird dadurch erreicht, dass anstatt einer glatten Edelmetall-Oberfläche eine raue Oberfläche der Edelmetallschicht vorliegt. Diese Oberflächenrauheit wird bereits in der unter der Edelmetallschicht liegenden Leiterlage, üblicherweise aus Kupfer, erzeugt, wobei die Oberflächenrauheit in einer Größenordnung herbeigeführt wird, die zumindest in der Größenordnung der Dicke der Edelmetallschicht, bevorzugt um eine Größenordnung größer vorgesehen wird. Dadurch bleibt diese Oberflächenrauheit der Leiterlage auch beim nachfolgenden Anbringen der Edelmetallschicht erhalten. Insbesondere kann die Oberflächenrauheit der Leiterlage im Bereich von 0,05 µm bis 5 µm, insbesondere 0,3 µm bis 3 µm, vorzugsweise 0,5 µm bis 1 µm, liegen, und die Dicke der Edelmetallschicht beträgt bevorzugt 0, 02 µm bis 1 µm, vorzugsweise 0,02 µm bis 0,5 µm. Die Oberfläche der Leiterlage kann beispielsweise durch chemisches Ätzen, durch mechanisches Bearbeiten oder galvanisch aufgeraut werden. Die Edelmetallschicht wird dann auf dieser aufgerauten Leiterlage beispielsweise stromlos oder aber galvanisch, durch Aufdampfen oder durch Sputtern aufgebracht. Als Edelmetall kann dabei mit Vorteil Silber, Gold, Palladium oder eine Kombination von einzelnen dieser Metalle oder aller dieser Metalle verwendet werden. Nach der Anbringung dieser vergleichsweise dünnen Edelmetallschicht auf der gesamten Oberfläche der Leiterlage (anstatt wie früher nur lokal in kleinen Teilbereichen), wobei die Rauheit der Oberfläche erhalten bleibt, können elektrische Bauelemente, wie insbesondere PTF-Widerstände etc., durch Aufdrucken, aufgebracht werden, und es kann dann ein Verpressen zu einem Multilayer erfolgen oder aber eine Lötstopmaske aufgebracht werden, um so in einem automatischen Lötvorgang auch vorgefertigte elektrische Bauelemente anbringen zu können.

Eine beispielhafte Herstellung gemäß der erfindungsgemäßen Technik sieht die folgenden grundlegenden Schritte vor:
a) Strukturieren der Kupfer-Leiterlage (üblicherweise in einem photolithographischen Prozess durch Ätzen).
b) Aufrauen der Oberfläche der Leiterlage
c) Aufbringen der Edelmetallschicht
d) Aufbringen der Bauelemente (z.B. PTF-Widerstände)
e) Verpressen zum Multilayer.

Dem gegenüber sind beim herkömmlichen Standardprozess folgende prinzipiellen Schritte notwendig:
a) Strukturieren der Leiterlage
b') Aufbringen eines gesonderten Haftvermittlers auf der Leiterlage (üblicherweise unter Anwendung eines Oxidationsprozesses und mit Hilfe von organischen Komponenten)
c') Aufbringen und Strukturieren einer Photo-Resistschicht
c'' ) Partielles Aufbringen der Edelmetallschicht
c''') Entfernen der Photo-Resistschicht
d) Aufbringen der Bauelemente
e) Verpressen zum Multilayer

Wie sich hieraus unmittelbar ersehen lässt, werden bei der erfindungsgemäßen Technik kostenintensive Schritte eingespart, wenn gemäß der Erfindung vorgegangen wird; überdies werden die Eigenschaften der Leiterplattenelemente verbessert.

Die Erfindung wird nachstehend anhand von bevorzugten Ausführungsbeispielen, auf die sie jedoch nicht beschränkt sein soll, und unter Bezugnahme auf die Zeichnung noch weiter erläutert. In der Zeichnung zeigen im Einzelnen:
Fig. 1 eine schematische Draufsicht auf ein Leiterplattenelement mit lokalen Edelmetallauflagen auf einer Kupferlage gemäß Stand der Technik;
Fig. 2 im größeren Maßstab einen schematischen Schnitt durch ein Teil dieser Leiterplattenelements, gemäß der Linie II-II und Fig. 1;
Fig. 3 eine der Darstellung in Fig. 1 entsprechende schematische Draufsicht auf ein Leiterplattenelement gemäß der Erfindung; und
Fig. 4 einen Querschnitt durch dieses Leiterplattenelement ähnlich der Darstellung in Fig. 2, wobei zusätzlich eine aufzupressende Leiterplattenstruktur mit Kupfer-Außenlage sowie eine untere Leiterlage veranschaulicht sind.

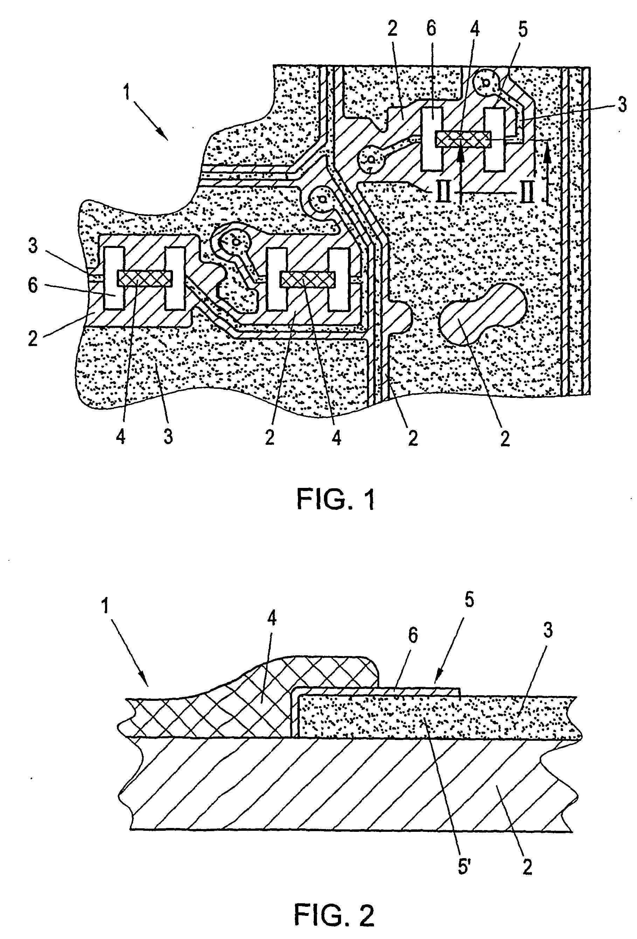

In Fig. 1 ist schematisch ein Teil eines Leiterplattenelements 1 in Draufsicht gezeigt, wobei der Schichtaufbau des Leiterplattenelements 1 weiters beispielhaft aus Fig. 2 hervorgeht.

In Fig. 1 sind einzelne Materialien des Leiterplattenelements 1, soweit sie an der Oberseite des Leiterplattenelements 1 ersichtlich sind, zwecks besserer Unterscheidung schraffiert, punktiert bzw. doppelt schraffiert veranschaulicht, wobei die einfach schraffierten Bereiche ein Epoxidharz-Substrat 2 darstellen (vgl. auch Fig. 2), auf dem eine strukturierte Metalllage 3, insbesondere aus Kupfer, vorliegt, die zwecks besserer Unterscheidung punktiert veranschaulicht ist. Diese Metalllage 3 wird nachfolgend der Einfachheit halber als Leiterlage 3 bezeichnet, und durch ihre Strukturierung (durch photolithographische Techniken) sind an der Oberseite jene Bereiche ersichtlich, d.h. freigelegt, in denen das an sich darunter liegende Epoxidharz-Substrat 2, nachstehend allgemein Leiterplatten-Substrat 2 oder kurz Substrat 2 genannt, dann von der Oberseite her zu sehen ist.

Mit doppelt schraffierten Linien sind weiters elektrische Bauelemente 4 gezeigt, bei denen es sich beispielsweise um in PTF-Technik (PTF-Polymer Thick Film-polymerer Dickfilm) aufgedruckte Bauelemente, insbesondere Widerstände, handelt. Im Bereich der Enden dieser Bauelemente 4, insbesondere Widerstände, sind Anschluss- oder Kontaktflächen 5 gebildet, die aus entsprechenden Bereichen 5' (siehe Fig. 2) der Leiterlage 3 sowie weiters lokal darauf aufgebrachten Edelmetall-Auflagen 6 gebildet sind. Diese Edelmetall-Auflagen 6 sind in Fig. 1 als freie Flächen, ohne Schraffur oder dergleichen, veranschaulicht, in der Querschnittsdarstellung gemäß Fig. 2 jedoch schraffiert gezeigt.

Die Edelmetall-Auflagen 6 bestehen in herkömmlicher Weise z.B. aus einer dünnen lokalen Silberschicht, und sie bilden eine Sperrschicht oder Stabilisierungsschicht, die beim Aufbringen der Bauelemente 4 und deren Fixierung (Aushärtung) einen Zugang von Feuchte zur Leiterlage 3 und damit im Kontaktbereich ein Korrodieren dieser Leiterlage 3 verhindern. Überdies verbessert diese Edelmetall-Auflage 6 auch den elektrischen Kontakt zwischen dem Bauelement 4 und der Leiterlage 3.

Von Nachteil ist bei dieser bekannten Technik, dass die Edelmetall-Auflage 6 nur lokal, in eng begrenzten Bereichen, nämlich den Bereichen der Kontaktflächen 5, aufgebracht werden darf. Würde eine derartige Edelmetall-Beschichtung auf der gesamten Leiterlage 3 aufgebracht werden, so würde eine nachfolgende Beschichtung des Leiterplattenelements 1 wie in Fig. 1 und 2 gezeigt, etwa mit einer weiteren Leiterplattenstruktur oder aber mit einer Lötstopmaske, nicht oder nur sehr schlecht haften, und eine relativ baldige Ablösung der aufgebrachten Schicht oder Schichten wäre die Folge.

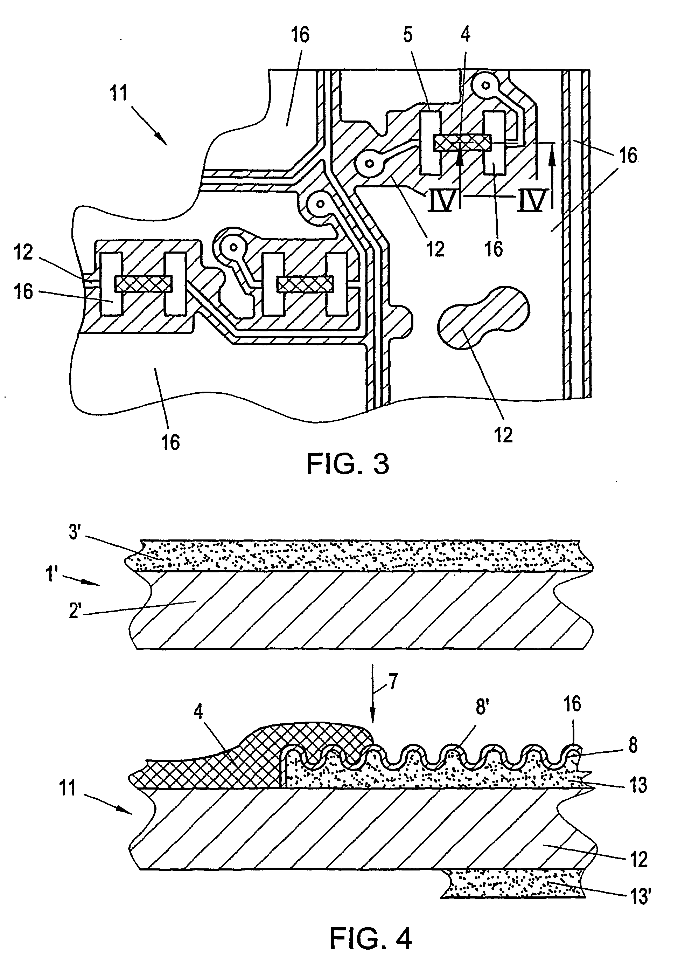

Anderseits ist für die bloß örtliche Aufbringung der Edelmetall-Auflagen 6 ein relativ hoher Aufwand bei der Herstellung notwendig, da gesonderte Schritte zur Maskierung der Oberseite des Leiterplattenelements 1 sowie zur Entfernung dieser Maskierung nach Aufbringen der Edelmetall-Auflagen 6 erforderlich sind. Überdies hat sich in der Praxis gezeigt, dass es im Bereich der Edelmetall-Auflagen 6 bei darüber angebrachten Schichten, etwa wenn das Leiterplattenelement 1 wie in Fig. 1 und 2 gezeigt zu einem Multilayer verpresst wird (vgl. auch Fig. 4), zu lokalen Abhebungen dieser aufgebrachten Schicht kommt, und dass insbesondere auch ein Abheben der Materialien der Bauelement 4 (PTF-Widerstände) von den Edelmetall-Auflagen 6 zu beobachten ist.

Bei der erfindungsgemäßen Technik wird, wie aus Fig. 3 ersichtlich, eine komplette Beschichtung der Leiterlage 13 auf dem Substrat 12 mit Edelmetall ermöglicht, und es liegt dann eine zur Gänze oder aber im Wesentlichen zur Gänze mit einer Edelmetallschicht 16 bedeckte Leiterlage 13 vor. Dadurch erübrigen sich die vorstehend erwähnten Maskierungs- und Demaskierungsprozesse, wie sie bei der bekannten Technik erforderlich sind. Nichtsdestoweniger wird ein ausgezeichnetes Haften von darüber angebrachten Bauelementen 4 und auch Schichten, wie beispielsweise eines Substrats 3' einer Leiterplattenstruktur 1', die eine äußere Leiterlage 3' aufweist, im Zuge des Verpressens zu einem Multilayer er-möglicht, vgl. Fig. 4, wo schematisch mit einem Pfeil 7 dieses Verpressen (wobei gleichzeitig eine Erhitzung erfolgt) veranschaulicht ist. Anstatt einer solchen Leiterplattenstruktur 1', wie in Fig. 4 gezeigt, kann beispielsweise aber auch eine Lötstopmaske auf der Oberseite des Leiterplattenelements 11 gemäß Fig. 3 und 4 angebracht werden. Auch hier wird eine gute Haftung erzielt.

Um diese gute Haftung zu erreichen, wird die Leiterlage 13 an ihrer Oberfläche vor dem Aufbringen der Edelmetallschicht 16 aufgeraut, wobei die Oberflächenrauheit 8 in Fig. 4 nur ganz schematisch mit einer Wellenlinie veranschaulicht ist. Dieser Oberflächenrauheit 8 der Leiterlage 13 folgt auch die vergleichsweise dünne Edelmetallschicht 16, so dass deren Oberseite ebenfalls eine entsprechende Rauheit 8' aufweist. Durch diese Oberflächenrauheit 8' wird sodann das erwähnte gute Anhaften einer darauf angebrachten Schicht, wie etwa einer Epoxidharz-Substratschicht 2' oder einer Lötstopmaske, sichergestellt.

Den vorliegenden Leiterplattenelementen 11 können herkömmliche Leiterplattensubstrate, wie etwa FR 4-Substrat, zu Grunde liegen, bei denen wie erwähnt ein Epoxidharz-Substrat 2 sowie darauf eine Kupferlage 13 gegeben sind. Gegebenenfalls kann das Substrat 2 aber auch auf der gemäß Darstellung in Fig. 4 unteren Seite mit einer Leiterlage (Kupferlage) 13' versehen sein, und diese Leiterlage 13' kann in entsprechender Weise aufgeraut und mit einer Edelmetallschicht versehen sein. Beim aufgebrachten Bauelement 4 handelt es sich bevorzugt um ein polymeres Dickfilm-Bauelement, insbesondere einen PTF-Widerstand, der in einem Druckverfahren aufgebracht wird. Ein solcher PTF-Widerstand besteht beispielsweise aus einem Phenolharz, in dem Kohlenstoffpartikel in der erforderlichen Konzentration, je nach Widerstandswert, eingelagert sind.

Die Edelmetallschicht 16 kann außer aus dem bereits erwähnten Silber auch aus Gold, aber auch aus Palladium, Platin oder dergleichen Edelmetall bestehen. Je nach den verwendeten Materialien werden auch entsprechende Aufrau- und Aufbringtechniken angewandt. Diese Techniken sind an sich bekannt und sollen daher hier nur kurz erwähnt werden.

Im Fall einer Edelmetallschicht 16 aus Silber wird bevorzugt eine einfache Austauschreaktion für die Beschichtung zu Grunde gelegt, bei der Kupfer der Leiterlage 3 durch Silber der Edelmetallschicht 16 gemäß der Beziehung 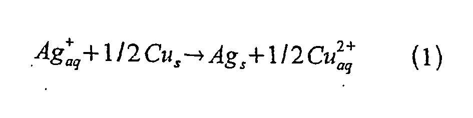 ersetzt wird.

Diese Austauschreaktion läuft zufolge der Potentialdifferenz zwischen Kupfer und Silber ab, und man erhält eine sehr kompakte Silberschicht auf der Kupferlage. Insbesondere werden hierbei Silber-Schichten 16 mit einer Dicke zwischen 0,1 µm und 0,25 µm herbeigeführt (allgemein bevorzugt zwischen 0,02 µm und 0,5 µm).

Im Fall einer Beschichtung mit Palladium wird ein Wasserstoff und Palladium enthaltender Aktivator aufgebracht, wobei eine autokatalytische Reaktion eingeleitet wird:

*Pd*°+*H*₂→*Pd*°+*2H_{ads}* (2)

*Pd*⁺⁺+2*H_{ads}*→*Pd*°+2*H* (3)

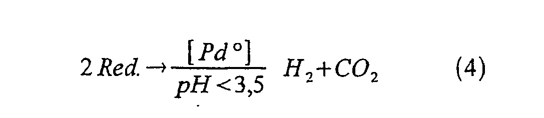

2*Red.+Pd*⁺⁺*→Pd*°⁺+2*H+CO*₂ (5)

Bei einem pH von < 3,5 beginnt die Zersetzung des Reduktionsmittels, und Reaktionen finden nur in der Diffusionsschicht statt. Der frei werdende Wasserstoff sichert die Fortführung der Reaktion.

Vergleichbare chemische Beschichtungstechniken können für Nickel und Gold angewandt werden.

Zur Aufbringung der Edelmetallschicht 16 auf der Leiterlage 3 können jedoch auch andere an sich herkömmliche Techniken eingesetzt werden, wie etwa ein galvanisches Aufbringen des Edelmetalls auf der Leiterlage 13, ein Aufbringen des Edelmetalls durch Aufdampfen oder ein Aufbringen durch Sputtern. Die Edelmetallschicht weist wie erwähnt mit Vorteil eine Dicke zwischen 0,02 µm und 1 µm auf.

Die Oberfläche der Leiterlage 13 kann, nachdem oder bevor sie in herkömmlicher Weise photolitographisch strukturiert wurde bzw. wird, durch verschiedenste an sich herkömmliche Techniken aufgeraut werden. Beispielsweise ist hier ein mechanisches Aufrauen denkbar, ebenso wie ein galvanisches Aufrauen oder ein Aufrauen durch Ionenätzen oder chemisches Ätzen, wobei als Ätzmittel beispielsweise ein solches auf der Basis von Wasserstoffperoxid/Schwefelsäure benutzt wird. Die Oberflächenrauheit kann in der Größenordnung von 0,05 µm bis 5 µm, vorzugsweise 0,3 µm bis 3 µm, insbesondere 0,5 µm bis 1 µm, liegen, und es werden dabei zum Teil nadelartige Oberflächenstrukturen erhalten. (Wie erwähnt ist die wellenartige Darstellung in Fig. 4 nur ganz schematisch zu sehen, sie soll jedoch auch verdeutlichen, dass die Oberflächenrauheit 8 bzw. 8' stärker ist, d.h. in einem größeren Dimensionsbereich liegt, verglichen mit der Dicke der Edelmetallschicht 16.)

## Patentansprüche

1. Verfahren zum Herstellen eines Leiterplattenelements, bei dem ausgehend von einem Leiterplatten-Substrat (12) mit zumindest einer Leiterlage (13) diese Leiterlage strukturiert sowie an der Oberfläche aufgeraut wird, wonach eine Edelmetallschicht (16) auf der gesamten strukturierten, aufgerauten Leiterlage (13) aufgebracht wird, wobei die Edelmetallschicht-Oberfläche eine entsprechende Rauheit (8') erhält, **dadurch gekennzeichnet, dass** nach dem Aufbringen der Edelmetallschicht (16) auf der aufgerauten Leiterlage (13) zumindest ein elektrisches Bauelement (4) auf Bereichen der oberflächen-rauen Edelmetallschicht (16) durch Aufdrucken angebracht wird.

2. Verfahren nach Anspruch 1, **dadurch gekennzeichnet, dass** die Oberfläche der Leiterlage (13) mit einer Rauheit (8) im Bereich von 0,05 µm bis 5 µm aufgeraut wird.

3. Verfahren nach Anspruch 2, **dadurch gekennzeichnet, dass** die Oberfläche der Leiterlage (13) mit einer Rauheit (8) im Bereich von 0,3 µm bis 3 µm aufgeraut wird.

4. Verfahren nach Anspruch 3, **dadurch gekennzeichnet, dass** die Oberfläche der Leiterlage (13) mit einer Rauheit (8) von 0,5 µm bis 1 µm aufgeraut wird.

5. Verfahren nach einem der Ansprüche 1 bis 4, **dadurch gekennzeichnet, dass** die Oberfläche der Leiterlage (13) durch chemisches Ätzen aufgeraut wird.

6. Verfahren nach einem der Ansprüche 1 bis 4, **dadurch gekennzeichnet, dass** die Oberfläche der Leiterlage (13) durch Ionenätzen aufgeraut wird.

7. Verfahren nach einem der Ansprüche 1 bis 4, **dadurch gekennzeichnet, dass** die Oberfläche der Leiterlage (13) durch mechanisches Bearbeiten aufgeraut wird.

8. Verfahren nach einem der Ansprüche 1 bis 4, **dadurch gekennzeichnet, dass** die Oberfläche der Leiterlage (13) galvanisch aufgeraut wird.

9. Verfahren nach einem der Ansprüche 1 bis 8, **dadurch gekennzeichnet, dass** die Edelmetallschicht (16) mit einer Dicke von 0,02 µm bis 1 µm auf der Leiterlage (13) aufgebracht wird.

10. Verfahren nach Anspruch 9, **dadurch gekennzeichnet, dass** die Edelmetallschicht (16) mit einer Dicke von 0,02 µm bis 0,5 µm aufgebracht wird.

11. Verfahren nach einem der Ansprüche 1 bis 10, **dadurch gekennzeichnet, dass** die Edelmetallschicht (16) chemisch-stromlos auf der Leiterlage (13) aufgebracht wird.

12. Verfahren nach einem der Ansprüche 1 bis 10, **dadurch gekennzeichnet, dass** die Edelmetallschicht (16) galvanisch auf der Leiterlage (13) aufgebracht wird.

13. Verfahren nach einem der Anprüche 1 bis 10, **dadurch gekennzeichnet, dass** die Edelmetallschicht (16) durch Aufdampfen auf der Leiterlage (13) aufgebracht wird.

14. Verfahren nach einem der Ansprüche 1 bis 10, **dadurch gekennzeichnet, dass** die Edelmetallschicht (16) durch Sputtern auf der Leiterlage (13) aufgebracht wird.

15. Verfahren nach einem der Ansprüche 1 bis 14, **dadurch gekennzeichnet, dass** als Edelmetallschicht (16) eine Schicht aus zumindest einem Metall der Gruppe, enthaltend Silber, Gold, Palladium und Platin, aufgebracht wird.

16. Verfahren nach einem der Ansprüche 1 bis 15, **dadurch gekennzeichnet, dass** das elektrische Bauelement (4) ein Widerstand ist.

17. Verfahren nach Anspruch 16, **dadurch gekennzeichnet dass** ein PTF-Widerstand auf der oberflächen-rauen Edelmetallschicht (16) angebracht wird.

18. Verfahren nach einem der Ansprüche 1 bis 17, **dadurch gekennzeichnet, dass** nach dem Aufbringen der Edelmetallschicht (16) auf der aufgerauten Leiterlage (13) sowie des elektrischen Bauelements (4) auf der Oberseite des Leiterplatten-Substrats (12), mit der oberflächen-rauen Edelmetallschicht (16), eine weitere Leiterplatten-Struktur (1') aufgebracht wird und so eine Verpressung zu einem Multilayer erfolgt.

19. Verfahren nach einem der Ansprüche 1 bis 17, **dadurch gekennzeichnet, dass** nach dem Aufbringen der Edelmetallschicht (16) auf der aufgerauten Leiterlage (13) sowie des elektrischen Bauelements (4) auf der Oberseite des Leiterplatten-Substrats (12), mit der oberflächen-rauen Edelmetallschicht (16), eine Lötstoppmaske aufgebracht wird.

20. Verfahren nach einem der Ansprüche 1 bis 19, **dadurch gekennzeichnet, dass** ein Leiterplatten-Substrat (12) mit zwei Leiterlagen (13, 13') verwendet wird, wobei zumindest eine Leiterlage strukturiert und aufgeraut wird.

21. Verfahren nach einem der Ansprüche 1 bis 20, **dadurch gekennzeichnet, dass** die Leiterlage nach dem Strukturieren an der Oberfläche aufgeraut wird.

22. Leiterplattenelement mit zumindest einer strukturierten Leiterlage (13) auf einem Substrat (12), welche eine aufgeraute Oberfläche (8) aufweist, wobei auf der gesamten aufgerauten Leiterlage (13) eine oberflächen-raue Edelmetallschicht (16) als Kontaktvermittler- und Stabilisierungsschicht einerseits und als Haftvermittlerschicht andererseits angebracht ist, **dadurch gekennzeichnet, dass** auf der oberflächen-rauen Edelmetallschicht (16) mindestens ein aufgedrucktes elektrisches Bauelement (4) angebracht ist.

23. Leiterplattenelement nach Anspruch 22, **dadurch gekennzeichnet, dass** auf der oberflächen-rauen Edelmetallschicht (16) eine weitere Leiterplattenstruktur (1'), unter Bildung einer Multilayer-Konfiguration, vorgesehen ist.

24. Leiterplattenelement nach Anspruch 22, **dadurch gekennzeichnet, dass** auf der oberflächen-rauen Edelmetallschicht (16) eine Lötstoppmaske aufgebracht ist.

25. Leiterplattenelement nach einem der Ansprüche 22 bis 24, **dadurch gekennzeichnet, dass** das elektrische Bauelement (4) ein Widerstand ist.

26. Leiterplattenelement nach Anspruch 25, **dadurch gekennzeichnet, dass** das elektrische Bauelement (4) ein PTF-Widerstand ist.

27. Leiterplattenelement nach einem der Ansprüche 22 bis 26, **dadurch gekennzeichnet, dass** die Leiterlage (13) bzw. die Edelmetallschicht (16) eine Oberflächenrauheit (8; 8') im Bereich von 0,05 µm bis 5 µm aufweist.

28. Leiterplattenelement nach Anspruch 27, **dadurch gekennzeichnet, dass** die Oberflächenrauheit (8) 0,3 µm bis 3 µm beträgt.

29. Leiterplattenelement nach Anspruch 28, **dadurch gekennzeichnet, dass** die Oberflächenrauheit (8) 0,5 µm bis 1 µm beträgt.

30. Leiterplattenelement nach einem der Ansprüche 22 bis 29, **dadurch gekennzeichnet, dass** die Edelmetallschicht (16) eine Dicke von 0,02 µm bis 1 µm aufweist.

31. Leiterplattenelement nach Anspruch 30, **dadurch gekennzeichnet, dass** die Edelmetallschicht (16) eine Dicke von 0,02 µm bis 0,5 µm aufweist.

32. Leiterplattenelement nach einem der Ansprüche 22 bis 31, **dadurch gekennzeichnet, dass** die Edelmetallschicht (16) zumindest ein Metall aus der Gruppe, bestehend aus Silber, Gold, Palladium und Platin, aufweist.

33. Leiterplattenelement nach einem der Ansprüche 22 bis 32, **dadurch gekennzeichnet, dass** das Substrat (12) zwei strukturierte Leiterlagen (13, 13') aufweist, wobei auf zumindest einer eine Edelmetallschicht (16) aufgebracht ist.

## Claims

1. A method for manufacturing a printed circuit board element, wherein starting from a printed circuit board substrate (12) with at least one conductor layer (13), this conductor layer is structured as well as roughened in the surface area, whereupon a noble metal layer (16) will be applied to the whole structured, roughened conductor layer (13), wherein the surface of the noble metal layer is provided with a corresponding roughness (8'), **characterized in that** after the noble metal layer (16) has been applied to the roughened conductor layer (13), at least one electric component (4) will be applied to the areas of the surface-rough noble metal layer (16) by imprinting.

2. A method according to claim 1, **characterised in that** the surface of the conductor layer (13) is roughened with a roughness (8) in the range of between 0.05 µm and 5 µm.

3. A method according to claim 2, **characterised in that** the surface of the conductor layer (13) is roughened with a roughness (8) in the range of between 0.03 µm and 3 µm.

4. A method according to claim 3, **characterised in that** the surface of the conductor layer (13) is roughened with a roughness (8) in the range of between 0.05 µm and 1 µm.

5. A method according to any one of claims 1 to 4, **characterised in that** the surface of the conductor layer (13) is roughened by chemical etching.

6. A method according to any one of claims 1 to 4, **characterised in that** the surface of the conductor layer (13) is roughened by ionic etching.

7. A method according to any one of claims 1 to 4, **characterised in that** the surface of the conductor layer (13) is roughened by mechanical processing.

8. A method according to any one of claims 1 to 4, **characterised in that** the surface of the conductor layer (13) is galvanically roughened.

9. A method according to any one of claims 1 to 8, **characterised in that** the noble metal layer (16) is applied to the conductor layer (13) with a thickness of between 0.02 µm and 1 µm.

10. A method according to claim 9, **characterised in that** the noble metal layer (16) is applied with a thickness of between 0.02 µm and 0.5 µm.

11. A method according to any one of claims 1 to 10, **characterised in that** the noble metal layer (16) is applied to the conductor layer (13) in chemical-currentless manner.

12. A method according to any one claims 1 to 10, **characterised in that** the noble metal layer (16) is galvanically applied to the conductor layer (13).

13. A method according to any one of claims 1 to 10, **characterised in that** the noble metal layer (16) is applied to the conductor layer (13) by evaporation.

14. A method according to any one of claims 1 to 10, **characterised in that** the noble metal layer (16) is applied to the conductor layer (13) by sputtering.

15. A method according to any one of claims 1 to 14, **characterised in that** a layer made of at least one metal from the group comprising silver, gold, palladium and platinum, is applied as the noble metal layer (16).

16. A method according to any one of claims 1 to 15, **characterised in that** the electric component (4) is a resistor.

17. A method according to claim 16, **characterized in that** a PTF resistor is applied to the surface-rough noble metal layer (16).

18. A method according to any one of claims 1 to 17, **characterised in that** after having applied the noble metal layer (16) to the roughened conductor layer (13) as well as after having mounted the electric component (4) to the upper side of the printed circuit board substrate (12) with the surface-rough noble metal layer (16), a further printed circuit board structure (1') is applied and thus a pressing to a multilayer is carried out.

19. A method acccording to any one of claims 1 to 17, **characterised in that** after having applied the noble metal layer (16) to the roughened conductor layer (13) as well as after having mounted the electric component (4) to the upper side of the printed circiut board substrate (12) with the surface-rough noble metal layer (16), a solder stop mask is applied.

20. A method according to any one of claims 1 to 19, **characterised in that** a printed circuit board substrate (12) with two conductor layers (13; 13') is used, wherein at least one conductor layer is structured and roughened.

21. A method according to any one of claims 1 to 20, **characterised in that**, after having been structured, the conductor layer is roughened in the surface area.

22. A printed circuit board element with at least one structured conductor layer (13) on a substrate (12), which substrate has a roughened surface (8), wherein a surface-rough noble metal layer (16) is positioned on the whole roughened conductor layer (13) and serves as contact promoting and stabilizing layer, on the one hand, and as adherence promoting layer, on the other hand, **characterized in that** at least one imprinted electric component (4) is mounted to the surface-rough noble metal layer (16).

23. A printed circuit board element according to claim 22, **characterised in that** a further printed circuit board structure (1') is provided on the surface-rough noble layer (16), forming a multilayer configuration.

24. A printed circuit board element according to claim 22, **characterised in that** a solder stop mask is applied to the surface-rough noble metal layer (16).

25. A printed circuit board element according to any one of claims 22 to 24, **characterised in that** the electric component (4) is a resistor.

26. A printed circuit board element according to claim 25, **characterized in that** the electric component (4) is a PTF resistor.

27. A printed circuit board element according to any one of claims 22 to 26, **characterised in that** the conductor layer (13) and the noble metal layer (16), respectively, have a surface roughness (8; 8') of between 0.05 µm and 5 µm.

28. A printed circuit board element according to claim 27, **characterized in that** the surface roughness (8) is 0.3 µm to 3 µm.

29. A printed circuit board element according to claim 28, **characterized in that** the surface roughness (8) is 0.5 µm to 1 µm.

30. A printed circuit board element according to any one of claims 22 to 29, **characterised in that** the noble metal layer (16) has a thickness of between 0.02 µm and 1 µm.

31. A printed circuit board element according to claim 30, **characterised in that** the noble metal layer (16) has a thickness of between 0.02 µm and 0.5 µm.

32. A printed circuit board element according to any one of claims 22 to 31, **characterised in that** the noble metal layer (16) has at least one metal selected from the group consisting of silver, gold, palladium and platinum.

33. A printed circuit board element acccording to any one of claims 22 to 32, **characterised in that** the substrate (12) has two structured conductor layers (13, 13'), wherein a noble metal layer (16) is applied to at least one of said conductor layers.

## Revendications

1. Procédé de fabrication d'un élément de carte de circuits imprimés, dans lequel, à partir d'un substrat (12) de carte de circuits imprimés comportant au moins une couche conductrice (13), cette couche conductrice est structurée et la surface de celle-ci rendue rugueuse, dans lequel une couche de métal noble (16) est déposée sur l'ensemble de la couche conductrice structurée et rendue rugueuse (13), dans lequel la superficie de la couche de métal noble présente une rugosité appropriée (8'), **caractérisé en ce que**, après le dépôt de la couche à métal noble (16) sur la couche conductrice rugueuse (13), au moins un composant électrique (4) est déposé par enfoncement en des zones de la couche de métal noble (16) à surface rugueuse.

2. Procédé selon la revendication 1, **caractérisé en ce que** la surface de la couche conductrice (13) est rendue rugueuse avec une rugosité (8) comprise entre 0,05 µm et 5 µm.

3. Procédé selon la revendication 2, **caractérisé en ce que** la surface de la couche conductrice (13) est rendue rugueuse avec une rugosité (8) comprise entre 0,3 µm et 3 µm.

4. Procédé selon la revendication 3, **caractérisé en ce que** la surface de la couche conductrice (13) est rendue rugueuse avec une rugosité (8) comprise entre 0,5 µm et 1 µm.

5. Procédé selon l'une des revendications 1 à 4, **caractérisé en ce que** la surface de la couche conductrice (13) est rendue rugueuse par gravure chimique.

6. Procédé selon l'une des revendications 1 à 4, **caractérisé en ce que** la surface de la couche conductrice (13) est rendue rugueuse par gravure ionique.

7. Procédé selon l'une des revendications 1 à 4,
**caractérisé en ce que** la surface de la couche conductrice (13) est rendue rugueuse par traitement mécanique.

8. Procédé selon l'une des revendications 1 à 4, **caractérisé en ce que** la surface de la couche conductrice (13) est rendue rugueuse par galvanisation.

9. Procédé selon l'une des revendications 1 à 8, **caractérisé en ce que** la couche de métal noble (16) est déposée sur la couche conductrice (13) avec une épaisseur de 0,02 µm à 1 µm.

10. Procédé selon la revendication 9, **caractérisé en ce que** la couche de métal noble (16) est déposée avec une épaisseur comprise entre 0,02 µm et 0,5 µm.

11. Procédé selon l'une des revendications 1 à 10, **caractérisé en ce que** la couche de métal noble (16) est déposée sur la couche conductrice (13) par un procédé chimique-sans courant.

12. Procédé selon l'une des revendications 1 à 10, **caractérisé en ce que** la couche de métal noble (16) est déposée sur le couche conductrice (13) par galvanisation.

13. Procédé selon l'une des revendications 1 à 10, **caractérisé en ce que** la couche de métal noble (16) est déposée sur le couche conductrice (13) par dépôt en phase vapeur.

14. Procédé selon l'une des revendications 1 à 10, **caractérisé en ce que** le couche de métal noble (16) est déposée sur la couche conductrice (13) par pulvérisation.

15. Procédé selon l'une des revendications 1 à 14, **caractérisé en ce que**, en tant que couche de métal noble (16), une couche en au moins un métal du groupe contenant l'argent, l'or, le palladium et le platine, est déposée.

16. Procédé selon l'une des revendications 1 à 15, **caractérisé en ce que** le composant électrique (4) est une résistance.

17. Procédé selon la revendication 16, **caractérisé en ce qu'**une résistance PTF est déposée sur la couche de métal noble à surface rugueuse (16).

18. Procédé selon l'une des revendications 1 à 17, **caractérisé en ce que**, après le dépôt de la couche de métal noble (16) sur la couche conductrice rugueuse (13) ainsi que du composant électrique (4) sur la surface du substrat de la carte de circuits imprimés (12), avec la couche de métal noble à surface rugueuse (16), une autre structure de carte de circuits imprimés (1') est déposée et il s'ensuit un pressage en une multicouche.

19. Procédé selon l'une des revendications 1 à 17, **caractérisé en ce que**, après le dépôt de la couche de métal noble (16) sur la couche conductrice rugueuse (13) ainsi que de l'élément électrique (4) sur le côté supérieur du substrat de la carte de circuits imprimés (12), avec la couche de métal noble à surface rugueuse (16), un masque de soudure est déposé.

20. Procédé selon l'une des revendications 1 à 19, **caractérisé en ce qu'**un substrat de carte de circuits imprimés (12) est utilisé avec de couche conductrice (13, 13'), dans lequel au moins une couche conductrice est structurée et rendue rugueuse.

21. Procédé selon l'une des revendications 1 à 20, **caractérisé en ce que** la couche conductrice est rendue rugueuse après structuration sur la surface.

22. Élément de carte de circuits imprimés comportant au moins une couche conductrice structurée (13) sur un substrat (12), qui présente une surface rendue rugueuse (8), dans lequel sur l'ensemble de la couche conductrice rendue rugueuse (13), une couche de métal noble à surface rugueuse (16) est déposée en tant que couche d'agent de contact et de stabilisation d'une part et en tant que couche d'agent de liaison d'autre part, **caractérisé en ce qu'**au moins un composant électrique enfoncé (4) est déposé sur la couche de métal noble à surface rugueuse (16).

23. Élément de carte de circuits imprimés selon la revendication 22, **caractérisé en ce qu'**une autre structure de carte de circuits imprimés (1') sous la forme d'une configuration à couches multiples, est prévue sur la couche de métal noble à surface rugueuse (16).

24. Élément de carte de circuits imprimés selon la revendication 22, **caractérisé en ce qu'**un masque d'arrêt de soudage est déposé sur la couche de métal noble à surface rugueuse (16).

25. Élément de carte de circuits imprimés selon l'une des revendications 22 à 24, **caractérisé en ce que** le composant électrique (4) est une résistance.

26. Élément de carte de circuits imprimés selon la revendication 25, **caractérisé en ce que** le composant électrique (4) est une résistance PTF.

27. Élément de carte de circuits imprimés selon l'une des revendications 22 à 26, **caractérisé en ce que** la couche conductrice (13) ou la couche de métal noble (16) présente une rugosité de surface (8 ; 8') comprise entre 0,05 µm et 5 µm.

28. Élément de carte de circuits imprimés selon la revendication 27, **caractérisé en ce que** la rugosité de surface (8) est comprise entre 0,3 µm et 3 µm.

29. Élément de carte de circuits imprimés selon la revendication 28, **caractérisé en ce que** la rugosité de surface (8) est comprise entre 0,5 µm et 1 µm.

30. Élément de carte de circuits imprimés selon l'une des revendications 22 à 29, **caractérisé en ce que** la couche de métal noble (16) présente une épaisseur de 0,02 µm à 1 µm.

31. Élément de carte de circuits imprimés selon la revendication 30, **caractérisé en ce que** la couche de métal noble (16) présente une épaisseur comprise entre 0,02 µm et 0,5 µm.

32. Élément de carte de circuits imprimés selon l'une des revendications 22 à 31, **caractérisé en ce que** la couche de métal noble (16) présente au moins un métal du groupe constitué par l'argent, l'or, le palladium et le platine.

33. Élément de carte de circuits imprimés selon l'une des revendications 22 à 32, **caractérisé en ce que** le substrat (12) présente deux couches conductrices structurées (13, 13'), dans lequel il est déposé sur au moins une couche de métal noble (16).
